# EUROPEAN PATENT APPLICATION

(11) **EP 4 697 380 A1**
(43) Date of publication of application: **18.02.2026**
(21) Application number: 25191923.9
(22) Date of filing: 25.07.2025
(51) Int. Cl.: H01L 23/15, H05K 1/03, C03C 17/40

(54) **PACKAGING SUBSTRATE AND METHOD OF MANUFACTURING THE SAME**

(30) Priority: 13.08.2024 US 202463682787 P
(71) Applicant: Absolics Inc., Covington, GA 30014 (US)
(72) Inventor: SHIN, Dongjun, Covington, Georgia, 30014 (US)
(74) Representative: BCKIP Part mbB

(57) **Abstract**

According to the present disclosure, a packaging substrate includes a glass core and an adhesion reinforcement layer disposed on the glass core. The adhesion reinforcement layer includes a first adhesion reinforcement layer and a second adhesion reinforcement layer disposed on the first adhesion reinforcement layer. The first adhesion reinforcement layer includes a transition metal and silicon. The second adhesion reinforcement layer includes a transition metal.

In such a case, it is possible to improve the bonding strength of the conductive layer with respect to the glass core, while effectively suppressing damage to the packaging substrate caused by the difference in thermal expansion properties between the glass core and the conductive layer.

## Description

### TECHNICAL FIELD

The present disclosure relates to a packaging substrate and a semiconductor package comprising the same.

### BACKGROUND

In manufacturing electronic components, forming a circuit on a semiconductor wafer is referred to as a front-end process (FE: Front-End), and assembling the wafer into a usable state in an actual product is referred to as a back-end process (BE: Back-End), and the packaging process is included in this back-end process.

The four core technologies of the semiconductor industry that have enabled the rapid development of electronic devices in recent years are semiconductor technology, semiconductor packaging technology, manufacturing process technology, and software technology. Semiconductor technology has evolved in various forms, such as sub-micron nanometer-scale line widths, tens of millions of cells, high-speed operation, and high heat emission; however, the technology for perfectly packaging these features has not developed to the same extent. Therefore, the electrical performance of a semiconductor may be determined not by the performance of the semiconductor technology itself but by the packaging technology and the resulting electrical connections.

Ceramic or resin is used as the material of the packaging substrate. In the case of a ceramic substrate, it is difficult to mount high-performance high-frequency semiconductor devices due to its high resistivity or high dielectric constant. In the case of a resin substrate, although it is relatively possible to mount high-performance high-frequency semiconductor devices, there is a limit in reducing the pitch of wiring.

Recently, research is being conducted on applying silicon or glass as high-end packaging substrates. A through hole is formed in the silicon or glass substrate, and a conductive material is applied to the through hole so that the wiring length between the device and the motherboard becomes shorter, and excellent electrical characteristics may be obtained.

### SUMMARY

A packaging substrate according to one embodiment of the present specification includes a glass core and an adhesion reinforcement layer disposed on the glass core.

The adhesion reinforcement layer includes a first adhesion reinforcement layer and a second adhesion reinforcement layer disposed on the first adhesion reinforcement layer.

The first adhesion reinforcement layer includes a transition metal and silicon.

The second adhesion reinforcement layer includes a transition metal.

The second adhesion reinforcement layer may include 50 atomic% or more of the transition metal.

A thickness of the adhesion reinforcement layer may be 50 nm or more and 300 nm or less.

Each of the first adhesion reinforcement layer and the second adhesion reinforcement layer may independently include any one selected from the group consisting of titanium, tungsten, tantalum, molybdenum, nickel, chromium, and combinations thereof.

The first adhesion reinforcement layer may be disposed in contact with an upper surface of the glass core.

The packaging substrate may include a first electrically conductive layer disposed on the glass core.

The first electrically conductive layer may include the adhesion reinforcement layer.

A peel strength of the first electrically conductive layer with respect to the upper surface of the glass core may be 250 gf/cm or more.

A ratio of an area where the upper surface of the glass core is in contact with the first electrically conductive layer to an entire area of the upper surface of the glass core may be 80% or less.

A method of manufacturing a packaging substrate according to another embodiment of the present specification includes: a preparation step of providing a base substrate including a glass core and a thin film for forming an adhesion reinforcement layer disposed on the glass core; a heat treatment step of heat-treating the base substrate to form a post-heat treatment substrate including the adhesion reinforcement layer; and a fabrication step of manufacturing the packaging substrate from the post-heat treatment substrate.

The thin film for forming the adhesion reinforcement layer includes a transition metal.

The adhesion reinforcement layer includes a first adhesion reinforcement layer and a second adhesion reinforcement layer disposed on the first adhesion reinforcement layer.

The first adhesion reinforcement layer includes a transition metal and silicon.

The second adhesion reinforcement layer includes a transition metal.

The method of manufacturing the packaging substrate may further include a cooling step of cooling the post-heat treatment substrate after the heat treatment step.

The cooling step may include a first cooling process and a second cooling process.

A cooling rate of the first cooling process may be 3°C/min or more.

A cooling rate of the second cooling process may be 2°C/min or less.

A heat treatment temperature in the heat treatment step may be 300°C or more.

In the heat treatment step, an ambient temperature may be increased at a rate of 15°C/10 min to 50°C/10 min.

The packaging substrate and the like of the present disclosure may exhibit excellent adhesion strength of an electrically conductive layer to a glass core, and generation of defects caused by thermal expansion characteristics between the glass core and the electrically conductive layer may be suppressed.

### BRIEF DESCRIPTION OF THE DRAWINGS

FIG. 1 is a cross-sectional view illustrating a packaging substrate according to an embodiment of the present disclosure.
FIG. 2 is a cross-sectional view illustrating a packaging substrate according to another embodiment of the present disclosure.
FIG. 3 is a cross-sectional view illustrating a packaging substrate according to still another embodiment of the present disclosure.

### DETAILED DESCRIPTION

Hereinafter, embodiments will be described in detail with reference to the accompanying drawings so that those skilled in the art to which the present invention pertains may easily carry out the invention. However, the invention may be implemented in various different forms and is not limited to the embodiments described herein. Throughout the entire specification, like reference numerals are used for similar parts.

Throughout the present specification, the phrase "combinations thereof" included in Markush-type expressions is intended to mean one or more mixtures or combinations selected from the group of elements described in the Markush-type expression, and to include at least one selected from the group of said elements.

Throughout the present specification, terms such as "first," "second," or "A," "B" are used to distinguish similar terms from one another. Also, singular forms include plural forms unless the context clearly indicates otherwise.

In the present specification, the term "~ based" may mean a compound including a compound corresponding to "~" or a derivative of "~".

In the present specification, when it is stated that B is located on A, it may mean that B is directly placed on A or that another layer is interposed between A and B while B is still located on A. It is not limited to an interpretation that B must be in direct contact with the surface of A.

In the present specification, when it is stated that B is connected to A, it may mean that A and B are directly connected, or connected via another component interposed between A and B, unless otherwise specified. It is not limited to direct connection.

In the present specification, singular expressions are interpreted to include both singular and plural meanings unless otherwise specifically stated.

In the drawings of the present specification, the shapes, relative sizes, and angles of each component may be exaggerated for illustrative purposes and explanation, and rights should not be construed as being limited to the drawings.

In the present specification, the expression that A and B are adjacent may mean that A and B are in contact or that A and B are positioned close to each other without being in contact. Unless otherwise specified, it is not limited to a meaning that A and B are in contact.

Unless otherwise specified in the present specification, the physical property values of each component in the packaging substrate are interpreted to be measured at room temperature. Room temperature is 20°C to 25°C.

Hereinafter, the present disclosure will be described in detail.

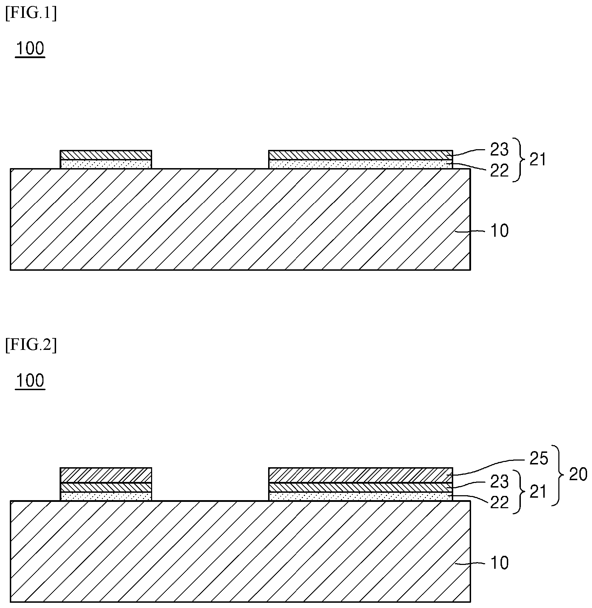

FIG. 1 is a cross-sectional view illustrating a packaging substrate according to an embodiment of the present disclosure. Hereinafter, the present disclosure will be described with reference to FIG. 1.

### Glass Core

A packaging substrate 100 according to the present disclosure may include a glass core 10.

The glass core 10 may have the shape of a glass substrate. The glass core 10 may, for example, be applied as an alkali borosilicate glass, an alkali-free borosilicate glass, an alkali-free alkali-earth borosilicate glass, and any glass sheet that may be used as an electronic component. The glass core 10 may be a glass substrate for an electronic device, and may, for example, be one manufactured by SCHOTT, AGC, or Corning, but is not limited thereto.

The glass core 10 may include a through via (not shown) penetrating in a thickness direction of the glass core 10.

The through via comprises an internal space (not shown) and a via inner surface (not shown) surrounding the internal space. The internal space refers to an empty space, and the via inner surface refers to a surface of the glass core 10 formed inside the through via.

The through via may have a diameter varying in the thickness direction of the glass core 10. The through via may have a substantially uniform diameter in the thickness direction of the glass core 10.

A surface of the glass core 10 may include an upper surface and a side surface formed in the thickness direction of the glass core 10 and connected to the upper surface. The surface of the glass core 10 may further include a lower surface facing the upper surface.

That the side surface is formed in the thickness direction of the glass core 10 is interpreted not only as the side surface forming a right angle with the upper surface but also as including a case in which at least a part of the side surface forms an angle (inclination) different from 90° with respect to the upper surface.

The side surface may be a flat surface or a curved surface.

The glass core 10 may include a cavity (not shown) that is a space formed by depression into the interior.

The cavity may be formed by a partial depression from the upper/lower surface side of the glass core 10 in the thickness direction, or may penetrate through the glass core 10 in the thickness direction.

A device may be mounted in the cavity, and the packaging substrate 100 and the device may be electrically connected. The device may be not only a semiconductor device such as a CPU, GPU, or memory chip, but also a capacitor device, transistor device, impedance device, or other modules. That is, any semiconductor device mounted on a semiconductor apparatus may be applied as the device without limitation.

A thickness of the glass core 10 may be 100 µm or more. The thickness may be 200 µm or more. The thickness may be 300 µm or more. The thickness may be 3000 µm or less. The thickness may be 2000 µm or less. The thickness may be 1000 µm or less. In such a case, the glass core 10 may have mechanical properties suitable for application to the packaging substrate 100.

### Adhesion Reinforcement Layer

The packaging substrate 100 includes the glass core 10 and an adhesion reinforcement layer 21 disposed on the glass core 10. The adhesion reinforcement layer 21 may be disposed in contact with an upper surface of the glass core 10. The adhesion reinforcement layer 21 may be a pattern having a predetermined position and shape.

The adhesion reinforcement layer 21 may help an electrically conductive layer to be fixed on the glass core 10. Specifically, the adhesion reinforcement layer 21 may improve the adhesion strength of the electrically conductive layer 20 with respect to the upper surface of the glass core 10.

The adhesion reinforcement layer 21 may include a first adhesion reinforcement layer 22 and a second adhesion reinforcement layer 23 disposed on the first adhesion reinforcement layer 22.

The first adhesion reinforcement layer 22 may be disposed on the upper surface of the glass core 10. The first adhesion reinforcement layer 22 may be disposed in contact with the upper surface of the glass core 10. The first adhesion reinforcement layer 22 may provide the first electrically conductive layer 20 with excellent adhesion strength to the upper surface of the glass core 10.

The present disclosure may apply both a transition metal and silicon to the first adhesion reinforcement layer 22. The first adhesion reinforcement layer 22 may include diffused Si derived from the glass core 10. In such a case, elements located under the first adhesion reinforcement layer 22 may be derived from the glass core 10 or may form covalent bonds with silicon present in the glass core 10. Through this, a first electrically conductive layer 20 with improved adhesion strength to the upper surface of the glass core 10 may be provided.

The first adhesion reinforcement layer 22, when observed in a cross-section in the thickness direction, may include a region where the silicon content increases toward the bottom. When observing the cross-section of the first adhesion reinforcement layer 22 in the thickness direction, the silicon content may increase toward the bottom of the first adhesion reinforcement layer 22. The first adhesion reinforcement layer 22 having such characteristics may be chemically bonded with the upper surface of the glass core 10.

The transition metal may be any one selected from the group consisting of titanium, tungsten, tantalum, molybdenum, nickel, chromium, and combinations thereof. The transition metal may be titanium or tungsten.

The first adhesion reinforcement layer 22 may further include elements other than the transition metal and silicon. The first adhesion reinforcement layer 22 may further include oxygen.

The second adhesion reinforcement layer 23 may include a transition metal.

The present disclosure may provide a controlled transition metal content in the second adhesion reinforcement layer 23, thereby imparting adjusted elasticity to the second adhesion reinforcement layer 23. In such a case, when the packaging substrate 100 is repeatedly exposed to a high-temperature atmosphere during the process of forming a redistribution layer, thermal stress on the glass core 10 caused by a difference in thermal expansion characteristics between the glass core 10 and the conductive layer may be effectively reduced.

The transition metal content in the second adhesion reinforcement layer 23 is measured by XPS (X-ray Photoelectron Spectroscopy).

The transition metal content in the second adhesion reinforcement layer 23 may be 50 atomic% or more. The content may be 60 atomic% or more. The content may be 70 atomic% or more. The content may be 80 atomic% or more. The content may be 90 atomic% or more. The content may be 95 atomic% or more. The content may be 100 atomic% or less. In such a case, while stably supporting the conductive layer, stress in the glass core 10 caused by thermal expansion and thermal contraction of the conductive layer may be reduced.

The transition metal may be any one selected from the group consisting of titanium, tungsten, tantalum, molybdenum, nickel, chromium, and combinations thereof. The transition metal may be titanium or tungsten.

The second adhesion reinforcement layer 23 may further include elements other than the transition metal. The second adhesion reinforcement layer 23 may further include oxygen.

Each of the first adhesion reinforcement layer 22 and the second adhesion reinforcement layer 23 may independently include any one selected from the group consisting of titanium, tungsten, tantalum, molybdenum, nickel, chromium, and combinations thereof. The first adhesion reinforcement layer 22 and the second adhesion reinforcement layer 23 may include the same transition metal.

A thickness of the adhesion reinforcement layer 21 may be 50 nm or more. The thickness may be 70 nm or more. The thickness may be 100 nm or more. The thickness may be 120 nm or more. The thickness may be 300 nm or less. The thickness may be 270 nm or less. The thickness may be 250 nm or less. The thickness may be 230 nm or less. The thickness may be 200 nm or less.

A thickness of the second adhesion reinforcement layer 23 may be 50 nm or more. The thickness may be 70 nm or more. The thickness may be 100 nm or more. The thickness may be 120 nm or more. The thickness may be 300 nm or less. The thickness may be 270 nm or less. The thickness may be 250 nm or less. The thickness may be 230 nm or less. The thickness may be 200 nm or less.

In such a case, while forming excellent adhesion strength between the glass core 10 and the first electrically conductive layer 20, it may contribute to suppressing crack generation in the glass core 10 caused by thermal expansion of the conductive layer under heating and cooling atmospheres.

### Conductive Layer and First Electrically Conductive Layer

FIG. 2 is a cross-sectional view illustrating a packaging substrate according to another embodiment of the present disclosure. Hereinafter, the present disclosure will be described with reference to FIG. 2.

The packaging substrate 100 includes the glass core 10 and an adhesion reinforcement layer 21 disposed on the glass core 10. The components of the packaging substrate 100 are the same as those described in FIG. 1 above. Hereinafter, differences will be described.

The packaging substrate 100 may include a first electrically conductive layer 20 disposed on the glass core 10. The first electrically conductive layer 20 is an electrically conductive layer disposed in contact with the upper surface of the glass core 10.

The first electrically conductive layer 20 may include the adhesion reinforcement layer 21. The first electrically conductive layer 20 may include the adhesion reinforcement layer 21 and a conductive layer 25 disposed on the adhesion reinforcement layer 21. The conductive layer 25 is a path through which an electric signal moves.

The conductive layer 25 may be disposed in contact with the adhesion reinforcement layer 21. The adhesion reinforcement layer 21 may be disposed in contact with the glass core 10. The conductive layer 25 may be disposed and fixed on the glass core 10 via the adhesion reinforcement layer 21.

The conductive layer 25 may include an electrically conductive material. For example, the conductive layer 25 may include at least one of copper, nickel, aluminum, gold, or silver. Copper or the like may be applied as the material of the conductive layer 25.

A peel strength of the first electrically conductive layer 20 with respect to the upper surface of the glass core 10 may be 250 gf/cm or more.

The peel strength of the first electrically conductive layer 20 with respect to the upper surface of the glass core 10 is measured by a bond tester according to the 180° peel test. The measurement speed (peel rate) is 10 mm/s, the measurement distance (peel distance) is 70 mm, and the measurement area is set to a region on the upper/lower surface of the glass core 10 where a through via is not formed. For example, the peel strength value may be measured using the Condor Sigma bond tester from XYZTEC.

The peel strength of the first electrically conductive layer 20 with respect to the upper surface of the glass core 10 may be 250 gf/cm or more. The peel strength may be 270 gf/cm or more. The peel strength may be 300 gf/cm or more. The peel strength may be 500 gf/cm or less. In such a case, the first electrically conductive layer 20 may be stably adhered on the glass core 10, and may help the packaging substrate 100 secure excellent electrical reliability.

A thickness of the first electrically conductive layer 20 may be 10 µm or more. The thickness may be 15 µm or more. The thickness may be 20 µm or more. The thickness may be 50 µm or less. In such a case, it may help secure high integration and stable electrical reliability of the packaging substrate 100.

A ratio of an area where the upper surface of the glass core is in contact with the first electrically conductive layer to the entire area of the upper surface of the glass core may be 80% or less.

The present disclosure may control the area occupied by the first electrically conductive layer on the upper surface of the glass core. Through this, it may help improve the integration of the packaging substrate while stably adjusting the increase in internal stress of the glass core caused by the mismatch in thermal expansion characteristics between the glass core and the first electrically conductive layer.

A ratio of an area where the upper surface of the glass core is in contact with the first electrically conductive layer to the entire area of the upper surface of the glass core may be 80% or less. The ratio may be 75% or less. The ratio may be 70% or less. The ratio may be 30% or more. The ratio may be 50% or more. In such a case, it may help stably control the frequency of crack generation in the glass core caused by forming a redistribution layer.

A resistance value of the first electrically conductive layer may be 0 MΩ or more. The resistance value of the first electrically conductive layer may be 0.1 MΩ or more. The resistance value of the first electrically conductive layer may be 0.4 MΩ or more. The resistance value of the first electrically conductive layer may be 0.8 MΩ or more. The resistance value of the first electrically conductive layer may be 1 MΩ or more. The resistance value of the first electrically conductive layer may be 2 MΩ or less. In such a case, it may contribute to the packaging substrate having excellent electrical reliability.

The resistance value of the first electrically conductive layer is measured by a 2-probe clamp meter on the upper side of the first electrically conductive layer at room temperature.

For example, the clamp meter may be model 3280-10F from HIOKI.

### Insulating Layer

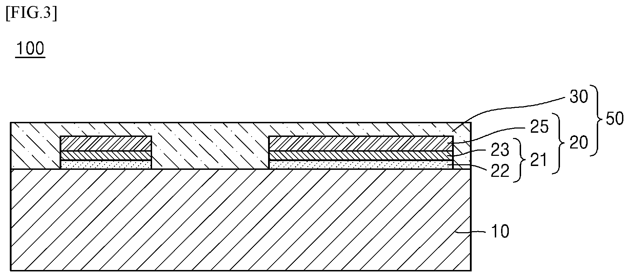

FIG. 3 is a cross-sectional view illustrating a packaging substrate according to another embodiment of the present disclosure. Hereinafter, the present disclosure will be described with reference to FIG. 3.

The packaging substrate 100 includes the glass core 10 and the adhesion reinforcement layer 21 disposed on the glass core 10. The components of the packaging substrate 100 are the same as those described in FIGS. 1 and 2 above. Hereinafter, differences will be described.

The packaging substrate 100 may further include an insulating layer 30 disposed on the first electrically conductive layer 20. The insulating layer 30 may surround at least a portion of the first electrically conductive layer 20. The insulating layer 30 may surround at least a portion of an upper surface of the first electrically conductive layer 20. The insulating layer 30 may surround at least a portion of a side surface of the first electrically conductive layer 20.

The insulating layer 30 and the first electrically conductive layer 20 may be disposed together on the glass core 10. The first electrically conductive layer 20 having a pattern shape may be embedded in the insulating layer 30.

The insulating layer 30 may be any material that can be applied as an insulating layer 30 in a semiconductor device or a packaging substrate 100. For example, the insulating layer 30 may include an epoxy-based resin containing filler. The insulating layer 30 may, for example, be formed using build-up layer materials such as Ajinomoto Build-up Film (ABF) from Ajinomoto, or undercoat materials, but is not limited thereto.

The insulating layer 30 may be formed by laminating an uncured or semi-cured insulating film and then curing it.

### Other Components

The packaging substrate 100 may include a first redistribution layer 50 disposed on the glass core 10. The first redistribution layer 50 may include the above-described first electrically conductive layer 20 and the insulating layer 30. The first redistribution layer 50 may further include a second electrically conductive layer (not shown) disposed on the first electrically conductive layer 20.

The first redistribution layer 50 may be electrically connected to a device mounted on the packaging substrate 100.

The second electrically conductive layer is an electrically conductive layer disposed on the glass core 10 and not in contact with the upper surface of the glass core 10. The second electrically conductive layer may be a pattern having a predetermined position and shape. The insulating layer 30 may surround at least a portion of the second electrically conductive layer. The insulating layer 30 and the second electrically conductive layer may be disposed together on the glass core 10. The second electrically conductive layer having a pattern shape may be embedded in the insulating layer 30.

The second electrically conductive layer may include the second adhesion reinforcement layer and a conductive layer disposed on the second adhesion reinforcement layer. Descriptions of the second adhesion reinforcement layer and the conductive layer are omitted as they are the same as previously described.

A thickness of the second electrically conductive layer may be 10 µm or more. The thickness may be 15 µm or more. The thickness may be 20 µm or more. The thickness may be 50 µm or less. In such a case, it may help ensure smooth transmission of electrical signals through the packaging substrate 100.

The first redistribution layer 50 may include two or more of the second electrically conductive layers. In the first redistribution layer 50, the second electrically conductive layer may have a width narrower than or equal to that of another second electrically conductive layer located beneath it. In the first redistribution layer 50, the second electrically conductive layer may have a thickness thinner than or equal to that of another second electrically conductive layer located beneath it.

In the first redistribution layer 50, the second electrically conductive layer may have a width narrower than or equal to that of the first electrically conductive layer 20. In the first redistribution layer 50, the second electrically conductive layer may have a thickness thinner than or equal to that of the first electrically conductive layer 20.

In such a case, the packaging substrate 100 may form an efficient electrical connection with the device mounted on the packaging substrate 100.

The packaging substrate 100 may further include a second redistribution layer (not shown) disposed beneath the glass core 10. The second redistribution layer may include a third electrically conductive layer (not shown) and an insulating layer, both disposed beneath the glass core 10.

When the packaging substrate 100 is mounted on a motherboard, the second redistribution layer may be electrically connected to the motherboard. The second redistribution layer may be electrically connected to the device mounted in the cavity.

At least a portion of the third electrically conductive layer may be disposed in contact with a lower surface of the glass core 10. The second redistribution layer may include two or more third electrically conductive layers.

The third electrically conductive layer may be a pattern having a predetermined position and shape. The insulating layer may surround at least a portion of the third electrically conductive layer. The insulating layer and the third electrically conductive layer may be disposed together on the glass core 10. The third electrically conductive layer having a pattern shape may be embedded in the insulating layer.

The third electrically conductive layer may include the second adhesion reinforcement layer and a conductive layer disposed on the second adhesion reinforcement layer. Descriptions of the second adhesion reinforcement layer, the conductive layer, and the insulating layer are omitted as they are the same as previously described.

The third electrically conductive layer may have a width greater than that of the widest of the second electrically conductive layers. The third electrically conductive layer may have a thickness greater than that of the thickest of the second electrically conductive layers.

The second redistribution layer may include two or more third electrically conductive layers. In the second redistribution layer, the third electrically conductive layer may have a width narrower than or equal to that of another third electrically conductive layer located beneath it. In the second redistribution layer, the third electrically conductive layer may have a thickness thinner than or equal to that of another third electrically conductive layer located beneath it. In such a case, the packaging substrate 100 may stably exchange electrical signals with a motherboard.

If necessary, bumps (not shown) may be arranged in a predetermined pattern beneath the second redistribution layer. The bumps may be disposed in a region on the lower surface of the packaging substrate 100 such that they come into contact with a motherboard or the like.

The first redistribution layer 50 and the second redistribution layer may be electrically connected. For example, when the glass core 10 includes a through via, the first redistribution layer 50 and the second redistribution layer may be connected through a redistribution layer (not shown) formed in the through via.

### Semiconductor Package

A semiconductor package according to another embodiment of the present disclosure includes the packaging substrate 100 and a device electrically connected to the packaging substrate 100.

The packaging substrate 100 may be mounted on a main board and electrically connected to the main board.

The packaging substrate 100 and the device may be the same as the packaging substrate 100 and the device described above. Descriptions of the packaging substrate 100 and the device are omitted as they are redundant with the above content.

### Method of Manufacturing the Packaging Substrate

A method of manufacturing a packaging substrate according to another embodiment of the present disclosure includes: a preparation step of providing a base substrate including a glass core and a thin film for forming an adhesion reinforcement layer disposed on the glass core; a heat treatment step of heat-treating the base substrate to form a post-heat treatment substrate; and a fabrication step of manufacturing the packaging substrate from the post-heat treatment substrate.

In the preparation step, the thin film for forming the adhesion reinforcement layer may be formed on the glass core to prepare the base substrate, or a base substrate on which the thin film for forming the adhesion reinforcement layer has already been formed on the glass core may be introduced.

Descriptions of the glass core are omitted as they are redundant with the above content.

The method of forming the thin film for forming the adhesion reinforcement layer on the glass core is not limited as long as it is a method commonly applied in the field of packaging substrates. For example, the thin film for forming the adhesion reinforcement layer may be formed by PVD (Physical Vapor Deposition), sputtering, electroless plating, or the like.

The thin film for forming the adhesion reinforcement layer may include a transition metal. The transition metal may be any one selected from the group consisting of titanium, tungsten, tantalum, molybdenum, nickel, chromium, and combinations thereof. The transition metal may be titanium or tungsten.

The content of the transition metal in the thin film for forming the adhesion reinforcement layer may be 50 atomic% or more. The content may be 60 atomic% or more. The content may be 70 atomic% or more. The content may be 80 atomic% or more. The content may be 90 atomic% or more. The content may be 95 atomic% or more. The content may be 100 atomic% or less.

A thickness of the thin film for forming the adhesion reinforcement layer may be 50 nm or more. The thickness may be 70 nm or more. The thickness may be 100 nm or more. The thickness may be 120 nm or more. The thickness may be 300 nm or less. The thickness may be 270 nm or less. The thickness may be 250 nm or less. The thickness may be 230 nm or less. The thickness may be 200 nm or less.

In such a case, it may help to form the composition, structure, and thickness of the adhesion reinforcement layer intended by the present disclosure.

In the heat treatment step, the base substrate may be heat-treated to form the post-heat treatment substrate. Specifically, by heat-treating the base substrate in a furnace or the like, silicon atoms or the like in the glass core may diffuse into the thin film for forming the adhesion reinforcement layer, thereby forming an adhesion reinforcement layer chemically bonded with the upper surface of the glass core.

A heating rate of the ambient temperature in the heat treatment step may be 15°C/10 min or more. The heating rate may be 18°C/10 min or more. The heating rate may be 20°C/10 min or more. The heating rate may be 25°C/10 min or more. The heating rate may be 30°C/10 min or more. The heating rate may be 50°C/10 min or less. The heating rate may be 40°C/10 min or less. In such a case, it may suppress damage to the glass core due to a rapid temperature change.

A heat treatment temperature in the heat treatment step may be 300°C or more. The heat treatment temperature may be 350°C or more. The heat treatment temperature may be 400°C or more. The heat treatment temperature may be 450°C or more. The heat treatment temperature may be 500°C or more. The heat treatment temperature may be 550°C or more. The heat treatment temperature may be 600°C or more. The heat treatment temperature may be 900°C or less.

In the heat treatment step, the base substrate may be heat-treated for 20 minutes or more. The base substrate may be heat-treated for 30 minutes or more. The base substrate may be heat-treated for 40 minutes or more. The base substrate may be heat-treated for 120 minutes or less.

In such a case, a sufficient number of silicon atoms or the like may diffuse into the thin film for forming the adhesion reinforcement layer.

The heat treatment temperature refers to the maximum value of the ambient temperature during the formation of the adhesion reinforcement layer.

The time required for heat treatment in the adhesion reinforcement layer formation step refers to the duration during which the ambient temperature is maintained at the maximum value.

In the heat treatment step, silicon atoms or the like derived from the glass core may diffuse into the lower part of the thin film for forming the adhesion reinforcement layer, thereby forming the first adhesion reinforcement layer and resulting in the formation of the post-heat treatment substrate. The post-heat treatment substrate may include the glass core and the adhesion reinforcement layer disposed on the glass core. The adhesion reinforcement layer may include the first adhesion reinforcement layer and the second adhesion reinforcement layer formed on the first adhesion reinforcement layer. The adhesion reinforcement layer may be formed in contact with the upper surface of the glass core. The first adhesion reinforcement layer may be formed in contact with the upper surface of the glass core.

Descriptions of the adhesion reinforcement layer, the first adhesion reinforcement layer, and the second adhesion reinforcement layer are omitted as they are redundant with the above content.

The method of manufacturing the packaging substrate may further include a cooling step of cooling the post-heat treatment substrate after the formation of the adhesion reinforcement layer. The present disclosure may rapidly cool the post-heat treatment substrate while suppressing damage to the glass core due to thermal stress in the glass core by performing a cooling step that applies different cooling rates over multiple processes.

The cooling step may include a first cooling process and a second cooling process.

The first cooling process may be a process of cooling the ambient temperature from the maximum value to 100°C. The second cooling process may be a process of cooling the ambient temperature from 100°C to room temperature.

The present disclosure may efficiently cool the post-heat treatment substrate by applying a predetermined or higher cooling rate in the first cooling process.

The cooling rate of the first cooling process may be 3°C/min or more. The cooling rate may be 3.5°C/min or more. The cooling rate may be 3.8°C/min or more. The cooling rate may be 4°C/min or more. The cooling rate may be 4.5°C/min or more. The cooling rate may be 8°C/min or less.

The first cooling process may be performed for 30 minutes or more. The first cooling process may be performed for 50 minutes or more. The first cooling process may be performed for 80 minutes or more. The first cooling process may be performed for 120 minutes or more. The first cooling process may be performed for 300 minutes or less.

In such a case, efficient cooling may be performed while suppressing damage to the substrate.

The present disclosure may suppress crack formation in the glass core caused by a mismatch in thermal contraction characteristics between the glass core and the adhesion reinforcement layer by cooling the post-heat treatment substrate at a controlled cooling rate in the second cooling process.

The cooling rate of the second cooling process may be 5°C/min or less. The cooling rate may be 3°C/min or less. The cooling rate may be 2°C/min or less. The cooling rate may be 0.1°C/min or more.

The second cooling process may be performed for 20 minutes or more. The second cooling process may be performed for 30 minutes or more. The second cooling process may be performed for 40 minutes or more. The second cooling process may be performed for 100 minutes or less.

In such a case, damage to the glass core caused by a mismatch in thermal expansion characteristics between the glass core and the adhesion reinforcement layer may be effectively suppressed.

In the fabrication step, the packaging substrate may be manufactured from the post-heat treatment substrate.

In the fabrication step, a conductive layer may be disposed on the adhesion reinforcement layer to form the first electrically conductive layer. First, a seed layer for forming the conductive layer may be formed on the adhesion reinforcement layer. The seed layer for forming the conductive layer may serve as a plating seed while having excellent adhesion strength to the adhesion reinforcement layer when forming the conductive layer through a plating process.

The seed layer for forming the conductive layer may include a metal element used for the conductive layer. The seed layer for forming the conductive layer may include an electrically conductive material. The seed layer for forming the conductive layer may include the same metal element as that included in the conductive layer. The seed layer for forming the conductive layer may include at least one of copper, nickel, aluminum, gold, or silver. The seed layer for forming the conductive layer may include copper.

The seed layer for forming the conductive layer may be formed by PVD (Physical Vapor Deposition), sputtering, electroless plating, or the like.

A thickness of the seed layer for forming the conductive layer may be 50 nm or more. The thickness may be 70 nm or more. The thickness may be 100 nm or more. The thickness may be 300 nm or less. In such a case, it may help to form a conductive layer with a desired thickness and thickness uniformity through a plating process as intended in the present disclosure.

A conductive layer may be formed by performing a plating process on the adhesion seed layer for forming the conductive layer. The plating process is not limited as long as it is a method commonly used in the packaging substrates. For example, an electroless plating process may be applied as the plating process.

Descriptions of the conductive layer and the first electrically conductive layer formed through the plating process are omitted as they are redundant with the above content.

Before performing the plating process, the adhesion reinforcement layer and the seed layer for forming the conductive layer may be patterned. Specifically, after forming a resist film in the region, the resist film may be developed according to a pre-designed pattern shape, and then the plating process may be performed. The resist film and the development of the resist film are not limited as long as they are commonly used in the field of packaging substrates.

Thereafter, the developed resist film may be removed, and the adhesion reinforcement layer and the seed layer for forming the conductive layer present in the region where the conductive layer is not formed may be removed, thereby completing the formation of the first electrically conductive layer. The adhesion reinforcement layer and the seed layer for forming the conductive layer may be removed by etching.

After the first electrically conductive layer is formed, an insulating layer-forming film may be laminated on the glass core and cured, or an insulating layer-forming composition may be coated on the glass core and cured to form the insulating layer and the first redistribution layer.

The insulating layer-forming film or the insulating layer-forming composition is not limited as long as it is commonly used in the field of build-up layers. Specifically, the insulating layer-forming film or the insulating layer-forming composition may be an epoxy-based resin film or composition.

The insulating layer may be formed to surround at least a portion of the first electrically conductive layer. The insulating layer may be formed to surround the upper surface of the glass core.

If necessary, after forming the insulating layer, a second electrically conductive layer may be formed thereon, and then another insulating layer may be formed on the second electrically conductive layer so as to surround it, thereby forming a multi-layer structure of the first redistribution layer.

The second electrically conductive layer may be formed by the same method as the formation of the first electrically conductive layer, except that heat treatment is not applied to the thin film for forming the adhesion reinforcement layer.

If necessary, a second redistribution layer including a third electrically conductive layer and an insulating layer surrounding the third electrically conductive layer may be formed under the glass core. The third electrically conductive layer may be formed by the same method as the formation of the first and/or second electrically conductive layers. However, in terms of width and/or thickness, the third electrically conductive layer may differ from the first or second electrically conductive layer.

The second redistribution layer may be formed by the same method as the formation of the first redistribution layer.

The method of manufacturing the packaging substrate may further include a step of forming a connection terminal, bump, cover layer, or the like on the upper and/or lower surface of the packaging substrate, or a step of mounting a device on the substrate.

Hereinafter, the present disclosure will be described in more detail through specific examples. The following examples are merely provided to aid understanding of the present disclosure, and the scope of the present disclosure is not limited thereto.

### Manufacturing Example: Formation of Packaging Substrate

Example 1: A base substrate was prepared by forming, through PVD, a titanium layer with a thickness of 150 nm as a thin film for forming the adhesion reinforcement layer on a glass substrate having a thickness of 400 µm. The base substrate was heat-treated to form a post-heat treatment substrate including an adhesion reinforcement layer. During the heat treatment, the heating rate was set to 23°C/10 min, the heat treatment temperature was set to 370°C, and the heat treatment time (i.e., time during which the maximum heat treatment temperature was maintained) was set to 50 minutes.

After completing the heat treatment, the post-heat treatment substrate was cooled. A first cooling process for cooling the ambient temperature from the maximum value to 100°C, and a second cooling process for cooling the ambient temperature from 100°C to 25°C were carried out. In the first cooling process, the cooling rate was set to 4.5°C/min and the cooling time was set to 60 minutes. In the second cooling process, the cooling rate was set to 1.25°C/min and the cooling time was set to 60 minutes.

A seed layer for forming the conductive layer, which was a copper layer with a thickness of 150 nm, was formed on the adhesion reinforcement layer through PVD. Then, a conductive layer with a thickness of 30 µm was formed on the seed layer through an electroless plating process, thereby forming the first electrically conductive layer and completing the packaging substrate.

Example 2: The packaging substrate was manufactured under the same conditions as Example 1, except that during the heat treatment of the base substrate, the heating rate was set to 35°C/10 min, the heat treatment temperature was set to 445°C, the cooling rate in the first cooling process was set to 3.83°C/min, and the cooling time was set to 90 minutes.

Example 3: The packaging substrate was manufactured under the same conditions as Example 1, except that during the heat treatment of the base substrate, the heating rate was set to 35°C/10 min, the maximum heat treatment temperature was set to 655°C, the heat treatment time was set to 30 minutes, the cooling rate in the first cooling process was set to 3.7°C/min, and the cooling time was set to 150 minutes.

Example 4: The packaging substrate was manufactured under the same conditions as Example 1, except that a tungsten layer with a thickness of 150 nm was applied as the thin film for forming the adhesion reinforcement layer.

Example 5: The packaging substrate was manufactured under the same conditions as Example 1, except that the thin film for forming the adhesion reinforcement layer and the seed layer for forming the conductive layer were formed by electroless plating.

Example 6: The packaging substrate was manufactured under the same conditions as Example 1, except that the thin film for forming the adhesion reinforcement layer and the seed layer for forming the conductive layer were formed by electroless plating, the heat treatment temperature was set to 500°C, the cooling rate in the first cooling process was set to 4.44°C/min, and the cooling time was set to 90 minutes.

Comparative Example 1: The packaging substrate was manufactured under the same conditions as Example 1, except that the heat treatment time was set to 20 minutes.

Comparative Example 2: The packaging substrate was manufactured under the same conditions as Example 1, except that the maximum heat treatment temperature was set to 255°C, the heat treatment time was set to 100 minutes, the cooling rate in the first cooling process was set to 3.88°C/min, and the cooling time was set to 40 minutes.

Comparative Example 3: The packaging substrate was manufactured under the same conditions as Example 1, except that in the cooling step for the post-heat treatment substrate, the ambient temperature was cooled from the maximum value to room temperature in a single process, and the cooling rate was set to 6.9°C/min and the cooling time was set to 50 minutes.

Each process condition of Examples and Comparative Examples is shown in Table 1 below.

### Evaluation Example: Measurement of Peeling Strength of First Conductive Layer

The peeling strength of a first conductive layer with respect to the upper surface of the glass core was measured for each of the packaging substrates of the Examples and Comparative Examples. The peeling strength of the first conductive layer with respect to the upper surface of the glass core was measured using the Condor Sigma bond tester of XYZ TEC in accordance with a 180° peel test. The measurement speed (peeling speed) was set to 10 mm/s, and the measurement distance (peeling distance) was set to 70 mm.

The measured values for each of the Examples and Comparative Examples are shown in Table 2 below.

### Evaluation Example: Measurement of Resistance of First Conductive Layer

The resistance of the first conductive layer was measured in the packaging substrates of each of the Examples and Comparative Examples. Specifically, the resistance of the upper side of the first conductive layer was measured at room temperature using a 2-probe of the clamp meter, model 3280-10F from Hioki.

The measured values for each of the Examples and Comparative Examples are shown in Table 2 below.

### Evaluation Example: Evaluation of Glass Core Damage

For each of the packaging substrates of the Examples and Comparative Examples, whether cracks occurred in the glass core was visually confirmed.

As a result of the confirmation, if no defect occurred, it was evaluated as "Pass", and if a defect occurred, it was evaluated as "Fail".

The evaluation results of each of the Examples and Comparative Examples are shown in Table 2 below.

**[Table 1]**

| | Heating Rate (°C/10 min) | Peak Temperature (°C) | Heating time (min) | Cooling Rate at the first cooling process (°C/min) | Cooling Rate at the second cooling process (°C/min) | Cooling Rate from Peak to Room Temperature (°C/min) |
|---|---|---|---|---|---|---|
| Example 1 | 23 | 370 | 50 | 4.5 | 1.25 | - |
| Example 2 | 35 | 445 | 50 | 3.83 | 1.25 | - |
| Example 3 | 35 | 655 | 30 | 3.7 | 1.25 | - |
| Example 4 | 23 | 370 | 50 | 4.5 | 1.25 | - |
| Example 5 | 23 | 370 | 50 | 4.5 | 1.25 | - |
| Example 6 | 23 | 500 | 50 | 4.4 | 1.25 | |
| Comparative Example 1 | 23 | 370 | 20 | 4.5 | 1.25 | - |
| Comparative Example 2 | 23 | 255 | 100 | 3.9 | 1.25 | - |
| Comparative Example 3 | 23 | 370 | 50 | - | - | 6.9 |

**[Table 2]**

| | Peeling Strength (gf/cm) | Resistance (MΩ) | Whether Glass Core is Damaged |
|---|---|---|---|
| Example 1 | 300 or more | 0.45 | Pass |
| Example 2 | 300 or | 0.10 | Pass |
| | more | | |
| Example 3 | 300 or more | 0.00 | Pass |
| Example 4 | 300 or more | 0.15 | Pass |
| Example 5 | 300 or more | 1.20 | Pass |
| Example 6 | 280 or more | 1.31 | Pass |
| Comparative Example 1 | 100 | 2.75 | Pass |
| Comparative Example 2 | 100 | 2.98 | Pass |
| Comparative Example 3 | 300 or more | N/A | Fail |

In Table 2 above, in Examples and Comparative Example 3, the peeling strength of the first conductive layer with respect to the upper surface of the glass core was measured to be 300 gf/cm or more, whereas in Comparative Examples 1 and 2, it was measured to be 100 gf/cm. This is considered to be because, in Comparative Examples 1 and 2, a sufficient thickness of the first adhesion reinforcing layer was not formed.

In terms of resistance, all of the Examples exhibited low resistance values of 2 MΩ or less, while Comparative Examples 1 and 2 exhibited high resistance values exceeding 2.5 MΩ, and in the case of Comparative Example 3, the resistance value could not be measured due to damage to the packaging substrate.

With respect to whether the glass core was damaged, Examples and Comparative Examples 1 and 2 were evaluated as Pass, while Comparative Example 3 was evaluated as Fail. This is considered to be because, in Comparative Example 3, excessive stress was applied to the glass core during the cooling process after heat treatment of the substrate.

While the preferred embodiments of the present invention have been described in detail above, the scope of rights of the present invention is not limited thereto, and various modifications and improvements by those skilled in the art using the basic concept of the present invention defined in the following claims are also within the scope of rights of the present invention.

## Claims

1. A packaging substrate, comprising:
a glass core; and
an adhesion reinforcement layer disposed on the glass core,
wherein the adhesion reinforcement layer comprises a first adhesion reinforcement layer and a second adhesion reinforcement layer disposed on the first adhesion reinforcement layer,
the first adhesion reinforcement layer comprises a transition metal and silicon, and
the second adhesion reinforcement layer comprises a transition metal.

2. The packaging substrate according to claim 1,
wherein the second adhesion reinforcement layer comprises 50 atomic% or more of the transition metal.

3. The packaging substrate according to claim 1,
wherein a thickness of the adhesion reinforcement layer is 50 nm or more and 300 nm or less.

4. The packaging substrate according to claim 1,
wherein the first adhesion reinforcement layer and the second adhesion reinforcement layer each independently comprise at least one selected from the group consisting of titanium, tungsten, tantalum, molybdenum, nickel, chromium, and combinations thereof.

5. The packaging substrate according to claim 1,
wherein the first adhesion reinforcement layer is disposed in contact with an upper surface of the glass core.

6. The packaging substrate according to claim 1, further comprising a first conductive layer disposed on the glass core,
wherein the first conductive layer includes the adhesion reinforcement layer, and
a peeling strength of the first conductive layer with respect to an upper surface of the glass core is 250 gf/cm or more.

7. The packaging substrate according to claim 1, further comprising a first conductive layer disposed on the glass core,
wherein the first conductive layer includes the adhesion reinforcement layer, and
a ratio of an area of an upper surface of the glass core in contact with the first conductive layer to a total area of the upper surface of the glass core is 80% or less.

8. A method of manufacturing a packaging substrate, comprising:
a preparation step of providing a base substrate including a glass core and a thin film for forming an adhesion reinforcement layer disposed on the glass core;
a heat treatment step of forming a post-heat treatment substrate including the adhesion reinforcement layer by heat-treating the base substrate; and
a fabrication step of manufacturing the packaging substrate from the post-heat treatment substrate,
wherein the thin film for forming the adhesion reinforcement layer includes a transition metal,
the adhesion reinforcement layer comprises a first adhesion reinforcement layer and a second adhesion reinforcement layer disposed on the first adhesion reinforcement layer,
the first adhesion reinforcement layer comprises a transition metal and silicon, and
the second adhesion reinforcement layer comprises a transition metal.

9. The method of manufacturing a packaging substrate according to claim 8, further comprising a cooling step of cooling the post-heat treatment substrate after the heat treatment step,
wherein the cooling step comprises a first cooling process and a second cooling process,
a cooling rate of the first cooling process is 3°C/min or more, and
a cooling rate of the second cooling process is 2°C/min or less.

10. The method of manufacturing a packaging substrate according to claim 9,
wherein a heat treatment temperature of the heat treatment step is 300°C or more.

11. The method of manufacturing a packaging substrate according to claim 9,
wherein, in the heat treatment step, an ambient temperature is increased at a rate of 15°C/10 min to 50°C/10 min.
